# EUROPÄISCHE PATENTSCHRIFT

(11) **EP 1 118 868 B1**
(45) Veröffentlichungstag und Bekanntmachung des Hinweises auf die Patenterteilung: **20.04.2005**
(21) Anmeldenummer: 00100952.1
(22) Anmeldetag: 18.01.2000
(51) Int. Cl.: G01R 31/317, G06K 19/073

(54) **Chipkartenschaltung mit überwachtem Zugang zum Testmodus**
Chip card circuit with monitored test mode access
Circuit pour carte à puce avec accès surveillé au mode de test

(43) Veröffentlichungstag der Anmeldung: 25.07.2001
(73) Patentinhaber: Infineon Technologies AG, 81669 München (DE)
(72) Erfinder: Wallstab, Stefan, 81739 München (DE)
(74) Vertreter: Epping, Hermann, Fischer

(56) Entgegenhaltungen:
- US-A- 5 305 267
- US-A- 5 617 366

## Beschreibung

Die Erfindung betrifft eine Schaltung für Chipkarten oder Sicherheit-Chips mit wenigstens einem einmalig schaltbaren Schaltelement, dessen Schaltzustand die Zugangsmöglichkeit zu einem Testmodus der Schaltung beeinflußt.

Bei der Herstellung von Chipkarten oder Sicherheit-Chips kommt es vor, daß ein Teil der Produktion an Drittfirmen vergeben wird. Beispielsweise wird die Montage oder der Einbau von Chips in Chipkarten von Drittfirmen vorgenommen. Da nach der Montage der Chips in die Chipkarten noch Testfunktionen ausgeführt werden müssen, kann der Testmodus vor der Auslieferung an die Drittfirma nicht endgültig gesperrt werden. Die Drittfirmen können daher gegebenenfalls eine detaillierte Analyse der Chips vornehmen.

Um den Zugang zum Testmodus der Chipschaltung zu sperren, sind im allgemeinen sogenannte OTP-Zellen (OTP = one time programable) vorgesehen. Bei den OTP-Zellen kann es sich sowohl um sogenannte Fuses oder Antifuses handeln. Die Fuses und Antifuses sind Bauelemente, die durch das Anlegen eines äußeren Signals in einen nicht-leitenden oder leitenden Zustand versetzt werden. Dabei ist jeweils nur ein Schaltvorgang möglich. Eine in den nicht-leitenden Zustand versetzte Fuse kann nicht in den leitenden Zustand zurückversetzt werden und eine in den leitenden Zustand versetzte Antifuse kann nachträglich nicht wieder in den nicht-leitenden Zustand zurückgebracht werden. Üblicherweise werden die Fuses oder Antifuses nach dem Abschluß des Herstellungsvorganges in den nicht-leitenden oder leitenden Zustand versetzt und damit der Zugang zum Testmodus der Chipsschaltung gesperrt. Eine derartige Schaltung ist aus der US-A-5617366 bekannt.

Da aber nach der Montage des Chips in einer Chipkarte durch eine Drittfirma noch Testfunktionen ausgeführt werden sollen, kann der Zugang zum Testmodus nicht endgültig gesperrt werden. Die Drittfirma hat somit ungehinderten Zugang zum Testmodus und kann gegebenenfalls detaillierte Analysen der Schaltung vornehmen.

Eine technische Lösung dieses Problems ist nicht bekannt. Deshalb wird bislang ausschließlich auf rechtliche und organisatorische Lösungen vertraut.

Ausgehend von diesem Stand der Technik liegt der Erfindung die Aufgabe zugrunde, eine Schaltung für Chipkarten oder Sicherheit-Chips zu schaffen, die unberechtigten Personen den Zugang zum Testmodus zumindest erschwert.

Diese Aufgabe wird erfindungsgemäß dadurch gelöst, daß ein beim Betätigen von wenigstens einem Schaltelement auftretender Schaltvorgang den Zugang zum Testmodus der Schaltung ermöglicht.

Da der Schaltvorgang als solcher die Schaltung in den Testmodus versetzt, muß für einen Eintritt in den Testmodus jeweils ein Schaltelement betätigt werden. Die Zahl der betätigten Schaltelemente entspricht somit der Zahl der Eintritte in den Testmodus. Wenn die Zahl der Eintritte in den Testmodus vor der Vergabe eines Auftrages an eine Drittfirma bekannt ist, kann ein unberechtigter Eintritt in den Testmodus der Drittfirma zumindest nachgewiesen werden. Auf diese Weise wird die Hemmschwelle deutlich erhöht.

Die der Anzahl von Schaltelementen entsprechende, begrenzte Zahl von möglichen Eintritten in den Testmodus ist kein Nachteil, da der Testmodus bei normalem Ablauf der Fertigung nur wenige Male benutzt werden muß. Daher kann man es sich leisten, den Eintritt in den Testmodus nicht vom Zustand der Schaltelemente, sondern vom Schaltvorgang selbst abhängig zu machen. Wenn die Schaltung in den Feldeinsatz entlassen wird, werden schließlich alle Schaltelemente betätigt und dadurch der Eintritt in den Testmodus endgültig gesperrt.

Bei einer weiteren vorteilhaften Ausgestaltung der Erfindung wird der Eintritt in den Testmodus von einem vorgegebenen Verlauf des Schaltvorganges abhängig gemacht.

Denn eine Reparatur des Schaltelementes und ein erneutes Auslösen führt im allgemeinen zu einem völlig anderen Verlauf des Schaltvorganges. Wenn nun ausschließlich ein bestimmter vorgegebener zeitlicher Verlauf des Schaltvorganges einen Eintritt in den Testmodus ermöglicht, ist auch der Umweg über die Reparatur eines Schaltelementes abgeschnitten. Es ist somit gar nicht oder nur mit unverhältnismäßig hohem Aufwand möglich, die von den Schaltelementen gebildete Sperre durch eine Reparatur einzelner Schaltelemente zu umgehen.

Zusätzlich kann die Zeit, während der ein Zugang zum Testmodus möglich ist, begrenzt werden, um eine Analyse der Schaltung durch unberechtigte Personen möglichst zu unterbinden.

Eine Weiterbildung der Erfindung enthält daher einen Zeitzähler, der vom Schaltvorgang gestartet wird, und der nach einer vorgegebenen Zeit den Testmodus erneut sperrt.

Weitergehende Ausgestaltungen der Erfindung sind Gegenstand der abhängigen Ansprüche.

Nachfolgend werden Ausführungsbeispiele der Erfindung im einzelnen anhand der beigefügten Zeichnung erläutert. Es zeigen:
- Figur 1: eine Schaltung für Chipkarten, die den Zugang zu einem Testmodus regelt;
- Figur 2: eine Schaltung, die mit Hilfe von einer Vielzahl von Schaltelementen den Zugang zu einem Testmodus regelt; und
- Figur 3: eine Schaltung, die den Verlauf des Schaltvorganges auswertet und auf diese Weise den Zugang zum Testmodus überwacht.

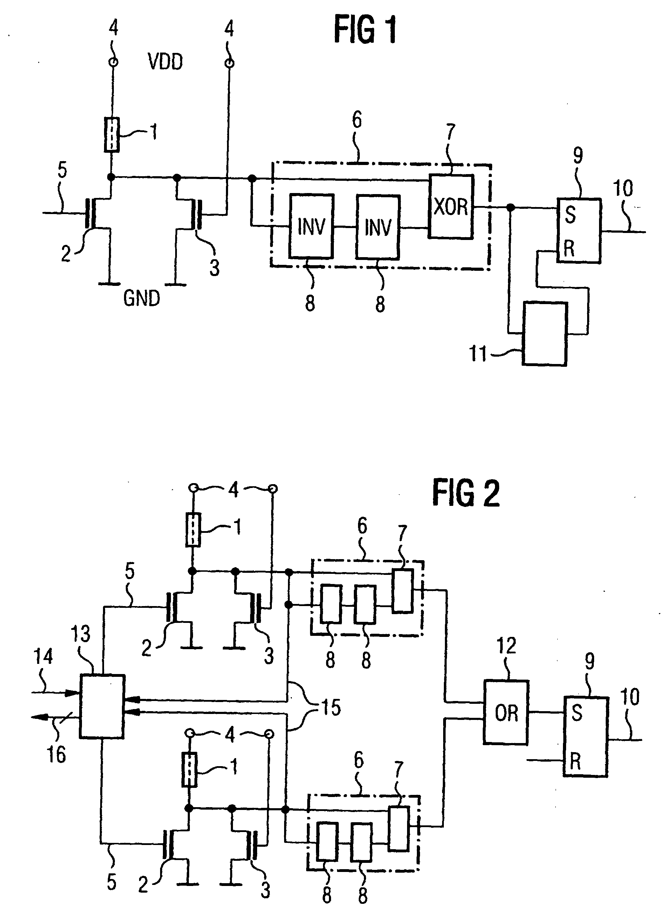

Figur 1 zeigt eine Zutrittskontrollschaltung für Chipkarten, die den Zugang zum Testmodus steuert. Die Schaltung verfügt über eine Schmelzbrücke 1, die in Reihe zu einem Zündtransistor 2 geschaltet ist. Parallel zum niederohmigen Zündtransistor 2 ist ein hochohmiger Sense-Transistor 3 geschaltet, der das masseseitige Ende der Schmelzbrücke 1 ständig auf einem definierten Potential hält. Wenn die Schmelzbrücke 1 noch nicht gezündet worden ist und sich somit im leitenden Zustand befindet, befindet sich das masseseitige Ende der Schmelzbrücke 1 auf dem Potential der an Anschlüssen 4 anliegenden Strom- und Spannungsversorgung. Wenn die Schmelzbrücke 1 durch Anlegen eines Steuersignals an einem Eingang 5 des Zündtransistors 2 gezündet wird, geht die Schmelzbrücke 1 in den nicht-leitenden Zustand über. Der Sense-Transistor 3 hält dann das masseseitige Ende der Schmelzbrücke 1 auf Massepotential. Dies ist auch dann der Fall, wenn der Zündtransistor 2 wieder abgeschaltet wird.

Dem von der Schmelzbrücke 1, dem Zündtransistor 2 und dem Sense-Transistor 3 gebildeten Spannungsteiler ist ein Flankendetektor 6 nachgeschaltet. Der Flankendetektor 6 umfaßt ein XOR-Gatter 7, dessen einem Eingang ein von zwei Invertern 8 gebildetes Gatter vorgeschaltet ist. Eine am Flankendetektor 6 anliegende Signalflanke löst am Anfang des Flankendetektors 6 einen Impuls aus, dessen Dauer der Gatterlaufzeit über die Inverter 8 entspricht. Denn an den Eingängen des XOR-Gatters 7 liegen dann kurzzeitig unterschiedliche Potentiale an, was die Bedingung dafür ist, daß das XOR-Gatter 7 eine logische 1 ausgibt. Der am Ausgang des Flankendetektors 6 ausgegebene Impuls kann zum Setzen eines RS-Flipflop 9 verwendet werden. Das an einem Ausgang 10 des RS-Flipflop 9 ausgegebene Signal ermöglicht schließlich den Zugang zum Testmodus der Chipschaltung. Beim Verlassen des Testmodus kann das RS-Flipflop 9 beispielsweise über Software zurückgesetzt werden.

Durch den von Flankendetektor 6 ausgegebenen Impuls kann auch ein Zeitzähler 11 mit festverdrahtetem Startwert gestartet werden, der nach der vorgegebenen Zeit das RS-Flipflop 9 zurücksetzt.

In Figur 2 ist eine Schaltung dargestellt, die über mehrere Schmelzbrücken 1 verfügt. Durch Zünden jeweils einer der Schmelzbrücken 1 wird der Zugang zum Testmodus der Chipschaltung ermöglicht. Dementsprechend ist bei dieser Schaltung zwischen die Ausgänge der Flankendetektoren 6 und dem RS-Flipflop 9 ein OR-Gatter 12 geschaltet. Um die einzelnen Schmelzbrücken 1 anzusteuern, und um die Zahl der bereits gezündeten Schmelzbrücken 1 zu erfassen, ist eine Steuereinheit 13 vorgesehen, die im einfachsten Fall einen an einen Eingang 14 angeschlossenen binären Zähler mit nachgeschaltetem 1-ausn Decoder aufweist. Die Steuereinheit 13 umfaßt ferner einen Prioritätsdecoder, der die auf Rückmeldeleitungen 15 anliegenden logischen Signale erfaßt und eine der Zahl der gezündeten Schmelzbrücken 1 entsprechende Zahl auf Ausleseleitungen 16 ausgibt.

Der Eintritt in den Testmodus der Chipschaltung setzt bei dem in Figur 1 und Figur 2 dargestellten Zutrittskontrollschaltungen voraus, daß eine der Schmelzbrücken 1 gezündet wird. Damit ist es möglich, bei der Vergabe von Montagearbeiten an Drittfirmen einen mißbräuchlichen Eintritt in den Testmodus nachzuweisen, wenn die Zahl der gezündeten Schmelzbrücken 1 nach der Ausführung eines Auftrages durch eine Montagefirma höher ist als vor der Auslieferung an die Montagefirma. Dadurch wird die Hemmschwelle deutlich erhöht.

Auch die Verweildauer im Testmodus kann mit einfachen Mitteln, wie bei dem in Figur 1 dargestellten Ausführungsbeispiel, begrenzt werden. Zweckmäßigerweise wird die Verweilzeit auf die Testzeit begrenzt, die bei einer ordnungsgemäßen Fertigung maximal benötigt wird.

Durch die Kopplung des Zutritts zum Testmodus an das Zünden einer der Schmelzbrücken 1 wird die Zahl der Eintritte in den Testmodus begrenzt. Dies ist jedoch nicht von Nachteil, da bei ordnungsgemäßer Fertigung nur eine begrenzte Zahl von Tests notwendig ist. Umgekehrt kann der Eintritt in den Testmodus durch Brennen aller Schmelzbrücken 1 endgültig gesperrt werden. Dies ist dann der Fall, wenn die Chipkarte in den Feldeinsatz entlassen wird und ein erneuter Eintritt in den Testmodus verhindert werden soll.

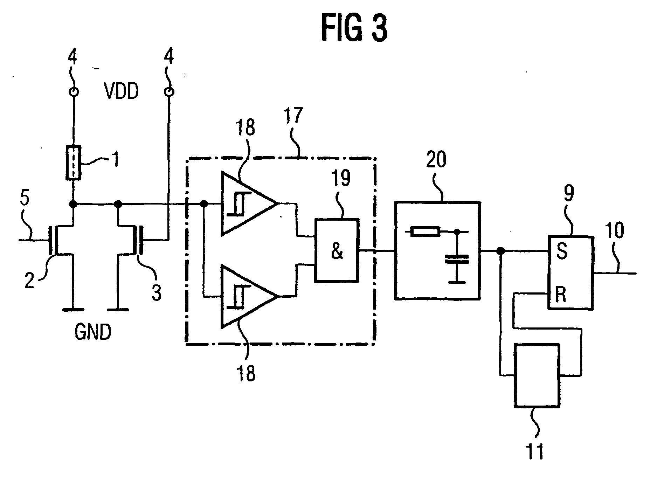

Um die Sicherheit der Zutrittskontrollschaltung zu erhöhen, kann der Eintritt in den Testmodus zusätzlich von einem bestimmten Strom- oder Spannungsverlauf beim Zünden der Schmelzbrücke 1 abhängig gemacht werden. Die in Figur 3 dargestellte Schaltung gewährt nur dann Zutritt zum Testmodus, wenn sich der Spannungsabfall am masseseitigen Ende der Schmelzbrücke 1 über eine gewisse Zeit erstreckt. Zu diesem Zweck ist ein Fensterkomparator 17 vorgesehen, der zwei parallel geschaltete Schmitt-Trigger 18 umfaßt, deren Ausgänge mit einem AND-Gatter 19 verbunden sind. Die Schaltniveaus der Schmitt-Trigger 18 sind so eingestellt, daß am Ausgang des Fensterkomparators 17 immer dann eine logische 1 erscheint, wenn die am Eingang des Fensterkomparators 17 anliegende Spannung zwischen den vorgegebenen Schaltschwellen der Schmitt-Trigger 18 liegen. Die Dauer des am Ausgang des Fensterkomparators 17 ausgegebenen Pulses ist somit für die Dauer des Spannungsabfalls am masseseitigen Ende der Schmelzbrücke 1 charakteristisch. Durch einen im einfachsten Fall durch ein RC-Glied gebildeten Zeit-Spannungswandler 20 am Ausgang des Fensterkomparators 17 wird ein zur Dauer dieses Pulses proportionales Spannungssignal erzeugt. Dieses Spannungssignal schaltet das RS-Flipflop nur dann, wenn dieses Spannungssignal die Schaltschwelle des RS-Flipflop 9 überschreitet. Der Zutritt zum Testmodus ist somit nur dann möglich, wenn die Spannung am masseseitigen Ende der Schmelzbrücke 1 ausreichend langsam abfällt. Bei einem Zünden der Schmelzbrücke 1 durch Ansteuern des Transistors 2 ist dies der Fall, da sich die Spannung zunächst auf einen Wert einstellt, der dem Verhältnis von Widerstand der Schmelzbrücke 1 und Innenwiderstand des Zündtransistors 2 entspricht, bevor sie nach dem Schmelzen der Schmelzbrücke 1 auf Massepotential abfällt. Demgegenüber würde ein Überbrücken der Schmelzbrücke 1 und ein Öffnen dieser Brücke ein sofortiges Abfallen der Spannung am masseseitigen Ende der Schmelzbrücke 1 zur Folge haben. Durch die Auswertung des zeitlichen Verlaufs des Schaltvorganges kann somit die Sicherheit der Zutrittskontrollschaltung erhöht werden.

Die hier vorgestellten Ausführungsbeispiele verwenden eine Schmelzbrücke oder sogenannte Fuse. Derartige Zutrittskontrollschaltungen lassen sich jedoch auch mit Hilfe von Antifuses oder allgemein OTP-Zellen (OTP = one time programable) verwirklichen. Von besonderem Vorteil ist dabei die Überwachung des zeitlichen Verlaufs beim Brennen der OTP-Zellen, wodurch eine Umgehung der Sicherung durch die OTP-Zellen praktisch unmöglich wird. Denn es ist im allgemeinen überhaupt nicht oder nur mit unverhältnismäßig hohem Aufwand möglich, eine OTP-Zelle so zu reparieren, daß sich beim erneuten Zünden der OTP-Zelle der gleiche Strom- und Spannungsverlauf wie beim erstmaligen Zünden ergibt.

## Patentansprüche

1. Schaltung für Chipkarten oder Sicherheit-Chips mit wenigstens einem einmalig schaltbaren Schaltelement (1), dessen Schaltzustand die Zugangsmöglichkeit zu einem Testmodus der Schaltung beeinflußt,
**dadurch gekennzeichnet,**
**daß** ein beim Betätigen von wenigstens einem Schaltelement (1) auftretender Schaltvorgang den Zugang zum Testmodus der Schaltung ermöglicht.

2. Schaltung nach Anspruch 1,
**dadurch gekennzeichnet,**
**daß** das Schaltelement von einer Schmelzbrücke (1) und einem dazu in Reihe geschalteten Zündtransistor (2) gebildet ist.

3. Schaltung nach Anspruch 1 oder 2,
**dadurch gekennzeichnet,**
**daß** die Schmelzbrücke zusammen mit dem Zündtransistor (2) und einem parallel zum Zündtransistor geschalteten Sense-Transistor (3) einen Spannungsteiler bildet, dem ein Flankendetektor (6) nachgeschaltet ist.

4. Schaltung nach Anspruch 1,
**dadurch gekennzeichnet,**
**daß** der Flankendetektor (6) eine bistabile Kippschaltung (9) beaufschlagt.

5. Schaltung nach Anspruch 1 oder 2,
**dadurch gekennzeichnet,**
**daß** ein bestimmter vorgegebener Verlauf des Schaltvorgangs den Zugang zum Testmodus der Schaltung ermöglicht.

6. Schaltung nach Anspruch 2 und 5,
**dadurch gekennzeichnet,**
**daß** die Schmelzbrücke zusammen mit dem Zündtransitor (2) und einem parallel zum Zündtransistor geschalteten Sense-Transistor (3) einen Spannungsteiler bildet, dem ein Fensterkomparator (17) nachgeschaltet ist, der einen Zeit-Spannungs-Wandler (20) beaufschlagt.

7. Schaltung nach Anspruch 6,
**dadurch gekennzeichnet,**
**daß** dem Zeit-Spannungswandler (20) eine bistabile Kippschaltung (9) nachgeschaltet ist.

8. Schaltung nach einem der Ansprüche 1 - 7,
**dadurch gekennzeichnet,**
**daß** der Schaltvorgang einen Zeitzähler (11) startet, der nach einer vorgegebenen Zeit den Zugang zum Testmodus sperrt.

9. Schaltung nach Anspruch 8,
**dadurch gekennzeichnet,**
**daß** der Zeitzähler (11) einen Eingang der bistabilen Kippschaltung (9) beaufschlagt.

10. Schaltung nach einem der Ansprüche 1 - 9,
**dadurch gekennzeichnet,**
**daß** die Schaltung über mehrere einzeln nacheinander betätigbare Schaltelemente (1) verfügt.

11. Schaltung nach Anspruch 10,
**dadurch gekennzeichnet,**
**daß** die Zahl der betätigten Schaltelemente (1) über eine Steuereinheit (13) auslesbar ist.

## Claims

1. Circuit for chip cards or security chips with at least one switching element (1) capable of being switched once, the switching state of which influences the possibility of access to a test mode of the circuit, **characterized in that** a switching operation, occurring when at least one switching element (1) is actuated, permits access to the test mode of the circuit.

2. Circuit according to Claim 1, **characterized in that** the switching element is formed by a fusible bridge (1) and a firing transistor (2) connected in series with the latter.

3. Circuit according to Claim 1 or 2, **characterized in that**, together with the firing transistor (2) and a sense transistor (3) arranged parallel to the firing transistor, the fusible bridge forms a voltage divider, downstream of which an edge detector (6) is arranged.

4. Circuit according to Claim 1, **characterized in that** the edge detector (6) acts on a bi-stable trigger circuit (9).

5. Circuit according to Claim 1 or 2, **characterized in that** a specific predetermined procedure of the switching operation permits access to the test mode of the circuit.

6. Circuit according to Claims 2 and 5, **characterized in that**, together with the firing transistor (2) and a sense transistor (3) arranged parallel to the firing transistor, the fusible bridge forms a voltage divider, downstream of which a window comparator (17), which acts on a time-voltage converter (20), .is arranged.

7. Circuit according to Claim 6, **characterized in that** a bi-stable trigger circuit (9) is arranged downstream of the time-voltage converter (20).

8. Circuit according to one of Claims 1 - 7,
**characterized in that** the switching operation starts a time counter (11), which blocks access to the test mode after a predetermined time.

9. Circuit according to Claim 8, **characterized in that** the time counter (11) acts on an input of the bistable trigger circuit (9).

10. Circuit according to one of Claims 1 - 9,
**characterized in that** the circuit has a plurality of switching elements (1) which can be individually actuated one after the other.

11. Circuit according to Claim 10, **characterized in that** the number of actuated switching elements (1) can be read out via a control unit (13).

## Revendications

1. Circuit pour des cartes à puce ou des puces de sécurité comprenant au moins un élément (1) de commutation pouvant être connecté une seule fois, dont l'état de commutation influe sur la possibilité d'accès à un mode de test du circuit,
**caractérisé**
**en ce qu'**une opération de commutation se produisant lors de l'actionnement d'au moins un élément (1) de commutation permet l'accès au mode de test du circuit.

2. Circuit suivant la revendication 1,
**caractérisé**
**en ce que** l'élément de commutation est formé par un pont (1 ) à fusible et un transistor (2) d'amorçage monté entre série avec celui-ci.

3. Circuit suivant la revendication 1 ou 2,
**caractérisé**
**en ce que** le pont à fusible forme, ensemble avec le transistor (2) d'amorçage et un transistor (3) sense monté en parallèle avec le transistor d'amorçage, un diviseur de tension en aval duquel est monté un détecteur (6) de front.

4. Circuit suivant la revendication 1,
**caractérisé**
**en ce que** le détecteur (6) de front alimente un circuit (9) bascule bistable.

5. Circuit suivant la revendication 1 ou 2,
**caractérisé**
**en ce qu'**un certain déroulement prescrit de l'opération de commutation permet l'accès au mode de test du circuit.

6. Circuit suivant la revendication 2 et 5,
**caractérisé**
**en ce que** le pont à fusible forme, ensemble avec le transistor (2) d'amorçage et un transistor (3) sense monté en parallèle au transistor d'amorçage, un diviseur de tension en aval duquel est monté un comparateur (17) à fenêtre qui alimente un convertisseur (20) temps-tension.

7. Circuit suivant la revendication 6,
**caractérisé**
**en ce qu'**un circuit (9) de bascule bistable est monté en aval du convertisseur (20) temps-tension.

8. Circuit suivant l'une des revendications 1 à 7,
**caractérisé**
**en ce que** l'opération de commutation fait démarrer un compteur (11) de temps qui, après une durée prescrite, bloque l'accès au mode de test.

9. Circuit suivant la revendication 8,
**caractérisé**
**en ce que** le compteur (11) de temps alimente une entrée du circuit (9) de bascule bistable.

10. Circuit suivant l'une des revendications 1 à 9,
**caractérisé**
**en ce que** le circuit dispose de plusieurs éléments (1) de commutation pouvant être actionnés les uns après les autres.

11. Circuit suivant la revendication 10,
**caractérisé**
**en ce que** le nombre des éléments (1) de commutation actionnés peut être lu par une unité (13) de commande.
